(19) Europäisches Patentamt
European Patent Office
Office européen des brevets

(11) **EP 4 037 125 A1**

(12) **DEMANDE DE BREVET EUROPEEN**

(43) Date de publication:
**03.08.2022 Bulletin 2022/31**

(21) Numéro de dépôt: **22153326.8**

(22) Date de dépôt: **25.01.2022**

(51) Classification Internationale des Brevets (IPC):
*H02H 9/04* (2006.01)  *H01L 27/02* (2006.01)

(52) Classification Coopérative des Brevets (CPC):
**H02H 9/046; H01L 27/0251; H01L 27/0259**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **29.01.2021 FR 2100868**

(71) Demandeur: **STMicroelectronics (Rousset) SAS
13790 Rousset (FR)**

(72) Inventeur: **TAILLIET, Francois
13710 FUVEAU (FR)**

(74) Mandataire: **Cabinet Beaumont
4, Place Robert Schuman
B.P. 1529
38025 Grenoble Cedex 1 (FR)**

(54) **DISPOSITIF DE PROTECTION CONTRE LES DÉCHARGES ÉLECTROSTATIQUES**

(57) La présente description concerne un dispositif (10) de protection contre les décharges électrostatiques comprenant un premier circuit écrêteur (16) relié entre un premier nœud (12) et un deuxième nœud (18) et un deuxième circuit écrêteur (20) actif, relié en série avec une première résistance (22), le deuxième circuit écrêteur et la première résistance étant reliés entre les premier et deuxième nœuds, le deuxième circuit écrêteur comprenant un transistor (28) à effet de champ à structure métal-oxyde-semiconducteur.

Fig 1

EP 4 037 125 A1

## Description

Domaine technique

La présente description concerne de façon générale les dispositifs électroniques et, plus particulièrement, les dispositifs électroniques de protection contre des décharges électrostatiques.

Technique antérieure

On connaît différents dispositifs de prévention et de protection contre les décharges électrostatiques, ou protection ESD ("ElectroStatic Discharge").

Résumé de l'invention

Il existe un besoin d'améliorer les performances des dispositifs de protection contre des décharges électrostatiques actuels.

Un mode de réalisation prévoit un dispositif de protection contre les décharges électrostatiques comprenant un premier circuit écrêteur relié entre un premier nœud et un deuxième nœud et un deuxième circuit écrêteur actif, relié en série avec une première résistance, le deuxième circuit écrêteur et la première résistance étant reliés entre les premier et deuxième nœuds, le deuxième circuit écrêteur comprenant un transistor à effet de champ à structure métal-oxyde-semiconducteur.

Selon un mode de réalisation, le deuxième circuit et la première résistance sont reliés l'un à l'autre par un troisième nœud, le troisième nœud étant le nœud de sortie du dispositif.

Selon un mode de réalisation, le transistor à effet de champ à structure métal-oxyde-semiconducteur est un transistor à canal N.

Selon un mode de réalisation, le deuxième circuit écrêteur a une résistance à l'état passant inférieure à 1 ohm.

Selon un mode de réalisation, la première résistance a une valeur inférieure à 100 ohms.

Selon un mode de réalisation, le premier circuit écrêteur comprend un transistor bipolaire.

Selon un mode de réalisation, le transistor bipolaire est un transistor de type NPN.

Selon un mode de réalisation, le premier circuit écrêteur comprend une deuxième résistance reliée entre la borne de commande du transistor bipolaire et le deuxième nœud.

Selon un mode de réalisation, la deuxième résistance a une valeur inférieure à 1 ohm.

Selon un mode de réalisation, le seuil d'écrêtage du premier circuit écrêteur est supérieur au seuil d'écrêtage du deuxième circuit écrêteur.

Un autre mode de réalisation prévoit un circuit électronique comprenant au moins un dispositif tel que décrit précédemment.

Selon un mode de réalisation, au moins deux dispositifs de protection partagent un même deuxième circuit.

Selon un mode de réalisation, le troisième nœud est relié à une borne du deuxième circuit écrêteur par une diode.

Selon un mode de réalisation, le troisième nœud de sortie d'un des dispositifs est relié à deux deuxièmes circuits, l'un étant partagé avec au moins un autre dispositif.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un mode de réalisation d'un dispositif de protection ESD ;

la figure 2 représente un circuit équivalent du mode de réalisation de la figure 1 ;

la figure 3 représente un exemple d'application du mode de réalisation de la figure 1 ; et

la figure 4 représente un autre exemple d'application du mode de réalisation de la figure 1.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

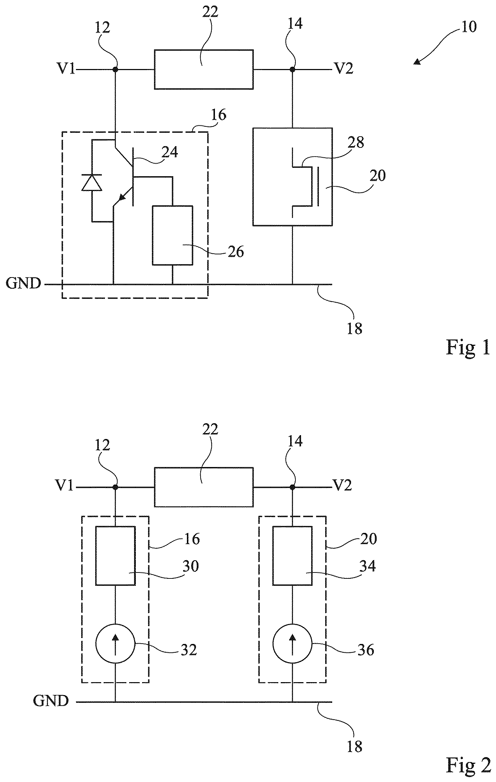

La figure 1 représente un mode de réalisation d'un dispositif de protection ESD 10. Le dispositif 10 est situé entre deux nœuds 12 et 14 et un rail, ou nœud, 18 d'application d'une tension de référence, de préférence la masse GND. Le dispositif 10 protège un circuit non représenté des décharges électrostatiques. La performance du dispositif 10 quant à cette protection est mesurée selon diverses normes parmi lesquelles la norme dite du modèle du corps humain ("Human Body Model").

Une tension V1 est appliquée sur le nœud 12 et une tension V2 est appliquée sur le nœud 14. Le dispositif 10 est situé dans un circuit électronique de manière à protéger des composants du circuit reliés du coté du nœud 14 de décharges apparaissant par exemple sur le nœud 12 ou des composants ou connecteurs reliés du côté du nœud 12 de décharges apparaissant par exemple sur le nœud 14.

Le dispositif 10 comprend un premier circuit écrêteur 16. Le circuit 16 est relié, de préférence connecté, entre le nœud 12 et le nœud 18. Autrement dit, une borne du circuit 16 est reliée, de préférence connectée, au nœud 12 et une autre borne du circuit 16 est reliée, de préférence connectée, au nœud 18.

Le dispositif 10 comprend un deuxième circuit écrêteur 20 relié, de préférence connecté, entre le nœud 14 et le nœud 18. Autrement dit, une borne du circuit 20 est reliée, de préférence connectée, au nœud 14 et une autre borne du circuit 20 est reliée, de préférence connectée, au nœud 18. Le dispositif 20 est un dispositif actif, c'est-à-dire que le dispositif 20 comprend au moins un composant actif. Le dispositif 10 comprend, en outre, une résistance 22 reliée entre les nœuds 12 et 14. Autrement dit, une borne de la résistance 22 est reliée, de préférence connectée, au nœud 12 et une autre borne de la résistance 22 est reliée, de préférence connectée, au nœud 14.

Par circuit écrêteur, on entend un circuit destiné à supprimer des surtensions, c'est-à-dire un circuit comprenant deux bornes et pouvant être dans un état passant ou dans un état bloqué. Lorsque le circuit est dans l'état passant, un courant peut circuler entre les deux bornes. Lorsque le circuit est dans l'état bloqué, un courant ne peut pas circuler entre les deux bornes. L'état du circuit écrêteur dépend de la tension entre lesdites deux bornes. Ainsi, si la tension entre lesdites deux bornes est inférieure à un seuil d'écrêtage, le circuit est dans l'état bloqué. Si la tension entre lesdites deux bornes est supérieure à un seuil d'écrêtage, le circuit est dans l'état passant.

De préférence, une des deux bornes est reliée, de préférence connectée, à un nœud d'application d'une tension de référence, par exemple la masse. Dans ce cas, l'état du circuit écrêteur dépend de la tension sur l'autre borne. Ainsi, si la tension sur ladite autre borne est inférieure à un seuil d'écrêtage, le circuit est dans l'état bloqué. Si la tension sur ladite autre borne est supérieure à un seuil d'écrêtage, le circuit est dans l'état passant. Lorsque la tension sur l'autre nœud atteint le seuil, par exemple lors d'une décharge électrostatique, l'énergie, et plus précisément le courant, peut être déchargé dans la masse.

Le circuit 16 est un circuit écrêteur ayant un seuil d'écrêtage supérieur au seuil d'écrêtage du circuit 20. Par exemple, le circuit 16 a un seuil d'écrêtage supérieur à deux fois le seuil d'écrêtage du circuit 20. Par exemple, le circuit 16 a un seuil d'écrêtage supérieur à 5 V, par exemple sensiblement égal à 7,5 V. Par exemple, le circuit 20 a un seuil inférieur à 5 V, par exemple sensiblement égal à 2,5 V.

De plus, le circuit 16 est par exemple configuré pour supporter un courant au moins égal à 3 A. Autrement dit, le circuit 16 est par exemple configuré pour qu'un courant d'au moins 3 A puisse le traverser sans l'endommager. De manière plus générale, le circuit 16 est par exemple configuré pour supporter un courant instantané de décharge de plusieurs ampères. Selon la norme Human Body Model, ce courant instantané en ampères est de l'ordre de Vzap / 1500, où Vzap est la tension de décharge, en volts.

Le circuit 16 comprend, par exemple, un transistor 24. Le transistor 24 est de préférence un transistor bipolaire, par exemple un transistor de type NPN. Le transistor 24 est relié, de préférence connecté, entre les nœuds 12 et 18. De préférence, une borne de conduction du transistor 24, de préférence le collecteur du transistor 24, est reliée, de préférence connectée, au nœud 12 et une autre borne de conduction du transistor 24, de préférence l'émetteur du transistor 24, est reliée, de préférence connectée, au nœud 18. Le circuit 16 comprend par exemple une résistance 26 reliée entre la borne de commande du transistor 24, par exemple la base, et le nœud 18. Autrement dit, une borne de la résistance 26 est reliée, de préférence connectée, à la base du transistor 24 et une autre borne de la résistance 26 est reliée, de préférence connectée, au nœud 18. De préférence, le circuit 16 comprend une diode, dont la cathode est reliée, de préférence connectée, au nœud 12 et dont l'anode est reliée, de préférence connectée, au nœud 18. La diode est par exemple une diode intrinsèque du transistor 24.

Le circuit 20 comprend un transistor à effet de champ à structure métal-oxyde-semiconducteur 28, ou transistor MOSFET ("Metal-Oxide-Semiconductor Field-Effect Transistor"). Le circuit 20 comprend par exemple uniquement le transistor 28. Le transistor 28 est de préférence un transistor MOSFET à canal N. Le transistor est relié, de préférence connecté, entre le nœud 14 et le nœud 18. Autrement dit, une borne de conduction du transistor 28, par exemple le drain, est reliée, de préférence connectée, au nœud 14 et une autre borne de conduction du transistor 28, par exemple la source, est reliée, de préférence connectée, au nœud 18. Le transistor 28 est un transistor commandé, c'est-à-dire un transistor dont le potentiel sur la grille est commandé par un circuit non représenté, par exemple un circuit extérieur au circuit 10, de sorte qu'en cas de détection d'une surtension positive entre le nœud 12 et le nœud 18, le potentiel de la grille augmente de façon à mettre le transistor 28 à l'état passant. Autrement dit, la grille du transistor 28 n'est pas commandée par un potentiel fixe ou constant lors du fonctionnement du dispositif 10. La grille du transistor 28 n'est pas relié à un nœud sur lequel est fourni un potentiel fixe ou constant lors du fonctionnement du dispositif 10.

Lors d'une décharge positive, par exemple sur le nœud 12, l'essentiel de l'énergie de la décharge passe par le circuit 16 qui fait passer le courant entre le nœud 12 et le nœud 18, par exemple la masse. Par exemple, dans le cas où le transistor 24 est un transistor NPN, celui-ci fonctionne en mode de claquage collecteur-émetteur. Le potentiel au niveau du circuit 16, c'est-à-dire sur le nœud 12, reste cependant trop élevé, le seuil d'écrêtage ne pouvant être diminué sans augmenter la surface du circuit de manière problématique. Le circuit 20 réduit ce potentiel à une valeur ne risquant pas d'endommager le dispositif relié au nœud 14. L'énergie transitant dans le circuit 20 est bien inférieure à l'énergie transitant dans le circuit 16.

Lors d'une décharge négative, la décharge passe par le circuit 16, plus précisément par la diode du circuit 16.

La figure 2 représente un circuit équivalent du mode de réalisation de la figure 1 lors d'une décharge. En particulier, la figure 2 représente un circuit équivalent au dispositif 10 de la figure 1 lorsqu'un pic de courant apparaît du côté du nœud 12, c'est-à-dire lorsque les circuits écrêteurs sont dans un état passant.

Le circuit équivalent comprend des éléments identiques aux éléments du dispositif 10 de la figure 1, qui ne seront pas détaillés de nouveau.

Le circuit équivalent diffère du dispositif de la figure 1 en ce que chaque circuit écrêteur 16, 20 est remplacé par un circuit équivalent, c'est-à-dire un circuit ayant des caractéristiques identiques, de préférence se comportant de manière identique. Plus précisément, chaque écrêteur est remplacé par une résistance et une source de tension en série, la résistance correspondant à la résistance à l'état passant et la valeur de la source de tension correspondant au seuil du circuit d'écrêtage.

Le circuit 16 comprend ainsi, dans la représentation équivalente, une résistance 30 en série avec une source de tension 32 entre les nœuds 12 et 18. Autrement dit, le circuit 16 se comporte comme un circuit comprenant la source 32 reliée, de préférence connectée, par une première borne au nœud 18 et par une deuxième borne à une première borne de la résistance 30, la deuxième borne de la résistance 30 étant reliée, de préférence connectée, au nœud 12. Le circuit 16 est par exemple choisi de manière à avoir une résistance à l'état passant inférieure à 5 ohms, de préférence inférieure à 1 ohm, par exemple inférieure à 500 milliohms, par exemple sensiblement égale à 100 milliohms. Le circuit 16 est par exemple choisi de manière à avoir un seuil d'écrêtage, correspondant à la valeur de la tension fournie par la source de tension 32 dans le circuit équivalent, supérieur à 5 V, par exemple sensiblement égal à 7,5 V.

Similairement, le circuit 20 comprend ainsi, dans la représentation équivalente, une résistance 34 en série avec une source de tension 36 entre les nœuds 14 et 18. Autrement dit, le circuit 20 se comporte comme un circuit comprenant la source 36 reliée, de préférence connectée, par une première borne au nœud 18 et par une deuxième borne à une première borne de la résistance 34, la deuxième borne de la résistance 34 étant reliée, de préférence connectée, au nœud 14. Le circuit 20 est par exemple choisi de manière à avoir une résistance à l'état passant inférieure à 5 ohms, de préférence inférieure à 1 ohm, par exemple sensiblement égale à 1 ohm. Le circuit 20 est par exemple choisi de manière à avoir un seuil d'écrêtage, correspondant à la valeur de la tension fournie par la source de tension 36 dans le circuit équivalent, inférieur à 5 V, par exemple sensiblement égal à 2,5 V.

Lorsqu'un pic de courant survient, par exemple sur le nœud 12, le circuit 16 entre dans un état passant et une partie de l'énergie est déchargée dans la masse par l'intermédiaire du circuit 16. Similairement, le circuit 20 entre dans l'état passant. Le dispositif fonctionne alors comme le circuit équivalent de la figure 2.

Les résistances 22 et 34 forment un diviseur de tension permettant d'obtenir une tension sur le nœud 14 inférieure à la tension sur le nœud 12. Ainsi, le circuit écrêteur 20 n'a pas besoin d'être configuré pour supporter des tensions et des courants aussi élevés que le circuit 16.

La tension d'écrêtage du dispositif 10 est dépendante des seuils intrinsèques des circuits écrêteurs 16 et 20 et des valeurs des résistances du dispositif 10. La tension d'écrêtage du dispositif 10 est inférieure au seuil du circuit 16, c'est-à-dire le seuil du circuit écrêteur situé du côté du nœud 12. La tension d'écrêtage du dispositif 10 est supérieure au seuil du circuit 20, c'est-à-dire le seuil du circuit écrêteur situé du côté du nœud 14.

La tension d'écrêtage du dispositif 10 lors d'une décharge est déterminée par l'équation suivante :

[Math 1]

$$VOUTS = S2 + \frac{(V1 - S2) * R2}{R2 + R3}$$

dans lequel VOUTS est la valeur du seuil d'écrêtage du dispositif 10, S2 est la valeur de seuil du dispositif 20, c'est-à-dire la valeur de la source de tension 36 (figure 2), R2 est la résistance à l'état passant du dispositif 20, c'est-à-dire la valeur de la résistance 34 (figure 2), et R3 est la valeur de la résistance 22.

La résistance 22 a de préférence une valeur relativement faible de manière à ne pas entraîner une perte d'énergie trop importante en mode de fonctionnement normal, c'est-à-dire lorsque les circuits écrêteurs sont dans un état bloqué, autrement dit lorsque la circuiterie interne au produit, reliée au nœud 14, dérive un courant significatif (typiquement vers le potentiel de masse) lors du fonctionnement normal du produit. Une perte de tension importante perturberait le fonctionnement du circuit. De préférence, la résistance 22 a une valeur inférieure à 100 ohms, de préférence comprise entre 10 ohms et 30 ohms, de préférence sensiblement égale à 20 ohms.

A titre de variante, le transistor 24 et la résistance 26 peuvent être remplacés par un autre circuit écrêteur apte à supporter un courant supérieur à 3 A, et ayant une résistance à l'état passant inférieure à 5 ohms, de préférence inférieure à 1 ohm, par exemple inférieure à 500 microohms, par exemple sensiblement égale à 100 microohms et un seuil d'écrêtage supérieur au seuil du circuit 20, par exemple supérieur à 5 V, par exemple sensiblement égal à 7,5 V.

On aurait pu choisir d'utiliser uniquement un circuit écrêteur tel que le circuit 16. Cependant, de tels circuits écrêteurs ne permettent pas d'obtenir des seuils d'écrêtage suffisamment bas. Le seuil d'écrêtage d'un tel circuit est supérieur à 5 V, en général supérieur à 7 V. Un tel circuit n'est pas adapté à la protection de composants pouvant être endommagés par une tension de l'ordre de 3 V ou inférieure à 3 V.

On aurait pu choisir d'utiliser uniquement un circuit écrêteur tel que le circuit 20. Cependant, l'énergie pouvant être déchargée dans la masse par un tel circuit dépend de la taille du transistor 28. Pour pouvoir faire face à un pic de courant élevé tout en ayant un seuil d'écrêtage relativement faible, c'est-à-dire par exemple inférieur à 5 V, les dimensions du transistor 28 devraient alors être importantes, avec par exemple une largeur de canal supérieure à 1 000 $\mu$m, par exemple supérieure à 10 000 $\mu$m, ce qui entraîne une forte perte de surface. De plus, de tels transistors comportent des fuites importantes, ce qui pénalise les performances du produit, en particulier en augmentant sa consommation au repos.

Un avantage des modes de réalisation décrits précédemment est qu'ils permettent de former un dispositif de protection ESD pouvant supporter un pic de courant important tout en ayant un seuil d'écrêtage bas. De plus, la surface du dispositif de protection ESD est avantageusement faible, en particulier en comparaison d'un dispositif comprenant uniquement un transistor 28, le transistor 28 du mode de réalisation de la figure 1 n'ayant à supporter qu'une faible partie du courant généré lors d'un pic de courant.

Un autre avantage du mode de réalisation décrit est que les courants de fuite du dispositif sont faibles par rapport à un dispositif de protection usuel, en particulier par rapport à un dispositif comprenant uniquement un circuit écrêteur tel que le circuit 20.

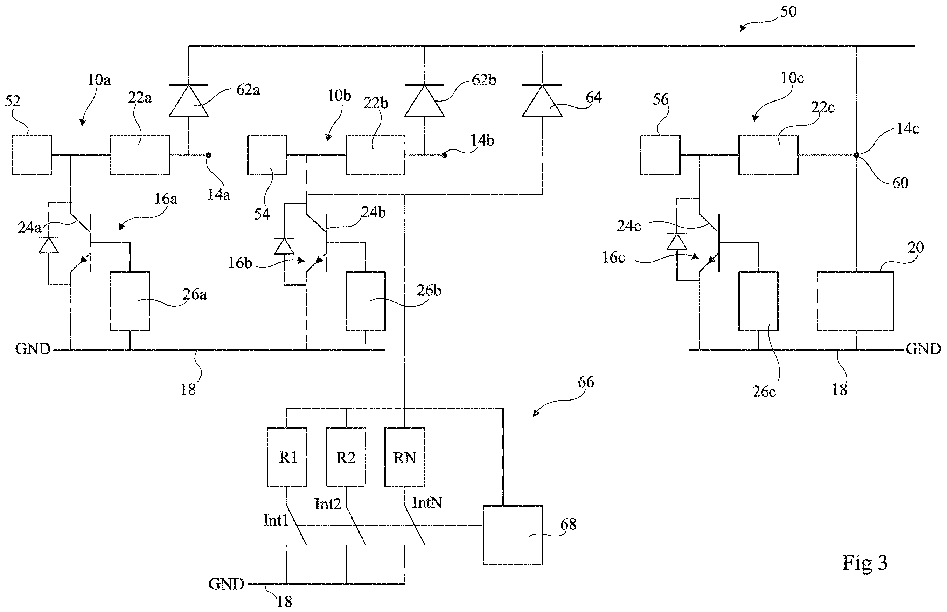

La figure 3 représente un exemple d'application du mode de réalisation de la figure 1. La figure 3 représente un circuit électronique 50.

Le circuit 50 comprend trois bornes 52, 54, 56, chacune représentée par un bloc. La borne 52 correspond par exemple à une entrée d'horloge, c'est-à-dire recevant un signal d'horloge, ou une entrée recevant un signal de commande d'écriture. La borne 54 correspond à une entrée/sortie recevant et émettant des données, par exemple des données binaires. La borne 56 est par exemple une borne d'alimentation, c'est-à-dire une entrée recevant la tension d'alimentation du circuit 50. De manière plus générale, le circuit 50 peut avoir un nombre quelconque de bornes.

Le circuit 50 comprend de préférence un dispositif de protection ESD ayant un fonctionnement similaire au dispositif de la figure 1 pour chaque borne. Ainsi, dans l'exemple de la figure 3, le dispositif 50 comprend trois dispositifs 10a, 10b et 10c. La borne 52 est reliée, de préférence connectée, au dispositif 10a, la borne 54 est reliée, de préférence connectée, au dispositif 10b, et la borne 56 est reliée, de préférence connectée, au dispositif 10c. De préférence, au moins certains dispositifs 10 partagent un même circuit 20. Dans l'exemple de la figure 3, les circuits 10 partagent tous le même circuit 20.

Plus précisément, le dispositif 10a comprend un circuit 16a, une résistance 22a et le circuit 20. Le circuit 16a est relié, de préférence connecté, entre la borne 52 et le nœud 18. Le circuit 16a comprend un transistor 24a et une résistance 26a. Le transistor 24a est, comme le transistor 24 de la figure 1, de préférence un transistor bipolaire, par exemple un transistor de type NPN. Le transistor 24a est relié, de préférence connecté, entre la borne 52 et le nœud 18. De préférence, une borne de conduction du transistor 24a, de préférence de collecteur du transistor 24a, est reliée, de préférence connectée, à la borne 52 et une autre borne de conduction du transistor 24a, de préférence d'émetteur du transistor 24a, est reliée, de préférence connectée, au nœud 18. La résistance 26a est de préférence reliée entre la borne de commande du transistor 24a, par exemple la base, et le nœud 18. Autrement dit, une borne de la résistance 26a est reliée, de préférence connectée, à la base du transistor 24a et une autre borne de la résistance 26a est reliée, de préférence connectée, au nœud 18.

La résistance 22a du circuit 10a est reliée, de préférence connectée, entre la borne 52 et un nœud de sortie 14a du dispositif 10a. Autrement dit, une borne de la résistance 22a est reliée, de préférence connectée, à la borne 52 et une autre borne de la résistance 22a est reliée, de préférence connectée, au nœud 14a.

Le nœud 14a est par exemple relié à d'autres éléments du circuit 50, étant protégés par les circuits 10. Le nœud 14a est, en outre, relié à une borne du circuit 20 commun aux dispositifs 10. Le nœud 14a est de préférence relié à une borne du circuit 20 par une diode 62a. La cathode de la diode 62a est reliée, de préférence connectée, à un nœud 60 correspondant à une borne du circuit 20. L'anode de la diode 62a est reliée, de préférence connectée, au nœud 14a.

Similairement, le dispositif 10b comprend une résistance 22b, un transistor 24b, une résistance 26b, le circuit 20 et une diode 62b reliés de la même manière. Ainsi, la résistance 22b est reliée entre la borne 54 et un nœud 14b de sortie du dispositif 10b. Le transistor 24b est relié par ses bornes de conduction entre la borne 54 et le nœud 18. La résistance 26b est reliée entre la borne de commande, c'est-à-dire la base, du transistor 24b et le nœud 18. Le nœud 14b est relié au nœud 60 par la diode 62b. Une anode de la diode 62b est reliée, de préférence connectée, au nœud 14b et la cathode de la diode 62b est reliée, de préférence connectée, à une borne du circuit 20.

La borne 54 est par exemple reliée, de préférence connectée, au nœud 60 par une diode 64. L'anode de la diode 64 est reliée, de préférence connectée, à la borne 54 et la cathode de la diode 64 est reliée, de préférence connectée, au nœud 60. La diode 64 est ainsi reliée en parallèle avec la diode 62b et la résistance 22b. La diode 64 permet de protéger la borne 54 d'une surtension.

Ladite borne, c'est-à-dire la borne 54 dans l'exemple de la figure 3, peut par exemple être reliée au nœud 18 par un ensemble résistif 66, dont la résistance totale peut varier. L'ensemble 66 comprend par exemple une pluralité d'associations en série d'une résistance R1, R2, RN et d'un interrupteur Int1, Int2, IntN, par exemple un transistor, par exemple un transistor MOS à canal N. Dans chaque association, une borne de la résistance est par exemple reliée, de préférence connectée, à la borne 54, une autre borne de la résistance est reliée, de préférence connectée, à une borne de l'interrupteur et une autre borne de l'interrupteur est reliée, de préférence connectée, au nœud 18. Les interrupteurs sont commandés par un circuit 68. Le circuit 68 est relié, de préférence connecté, aux bornes de commande des interrupteurs Int1, Int2, IntN. Le circuit 68 fournit les signaux de commande des interrupteurs.

Similairement, le dispositif 10c comprend une résistance 22c, un transistor 24c, une résistance 26c, et le circuit 20 reliés de la même manière. Ainsi, la résistance est reliée entre la borne 56 et un nœud 14c de sortie du dispositif 10c. Le transistor 24c est relié par ses bornes de conduction entre la borne 56 et le nœud 18. La résistance 26c est reliée entre la borne de commande, c'est-à-dire la base, du transistor 24c et le nœud 18. Le nœud 14c est relié, de préférence connecté, au nœud 60. De préférence, le nœud 14c, c'est-à-dire le nœud de sortie du dispositif 10c relié à la borne d'alimentation, n'est pas relié au nœud 60 par une diode.

La présence des diodes 62 permet, avantageusement, aux dispositifs 10 d'avoir un circuit 20 commun. En effet, la présence d'un pic de courant sur une des bornes modifie la tension sur le nœud 14c, mais n'impacte pas les autres nœuds 14. Autrement dit, les diodes 62a, 62b permettent de mutualiser le circuit 20, représenté en figure 3 comme une partie du dispositif 10c, pour les dispositifs 10a ou 10b (entrées ou entrées-sorties). Ainsi, le dispositif 10a constitue un dispositif tel que le dispositif de la figure 1, dans lequel le circuit 20 de la figure 1 est remplacé par la diode 62a et le circuit 20 de la figure 3. Similairement, dans le cas du dispositif 10b, le circuit 20 de la figure 1 est remplacé par la diode 62b et le circuit 20 de la figure 3. Les diodes 62a et 62b permettent également d'éviter des conflits électriques entre les dispositifs 10a, 10b et 10c en fonctionnement normal, la tension maximale en entrée des dispositifs 10a, 10b et 10c en fonctionnement normal du circuit étant inférieure ou égale à la tension d'alimentation de la charge reliée au nœud 60.

Par exemple, au moins certains des dispositifs 10, par exemple tous les dispositifs 10, sont identiques, c'est-à-dire que les résistances 22a, 22b, 22c, les transistors 24a, 24b, 24c et les résistances 26a, 26b, 26c sont identiques entre eux. De même, les diodes 62a, 62b sont par exemple identiques entre elles. A titre de variante, au moins certains dispositifs 10 peuvent avoir des caractéristiques différentes.

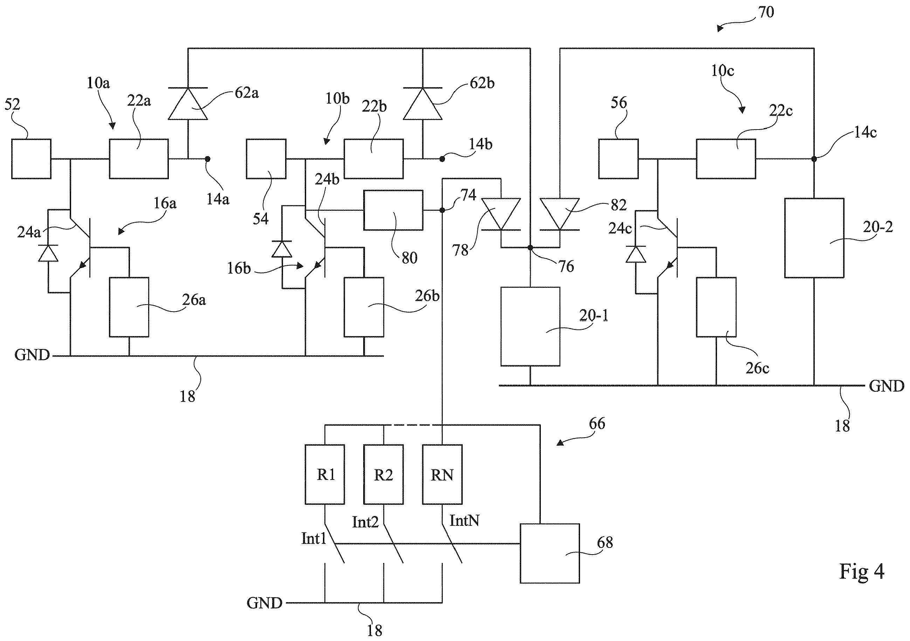

La figure 4 représente un autre exemple d'application du mode de réalisation de la figure 1. La figure 4 représente un circuit électronique 70.

Le circuit 70 comprend des éléments identiques au circuit 50. En particulier, le circuit 70 comprend les bornes 52, 54, 56. De plus, le circuit 70 comprend les dispositifs 10a, 10b, 10c.

Le dispositif 70 diffère du dispositif 50, entre autres, en ce que les dispositifs 10a, 10b d'une part, et le dispositif 10c d'autre part, comprennent des circuits 20 distincts.

Plus précisément, le dispositif 10a est relié, de préférence connecté, à la borne 52. Le dispositif 10a comprend, comme décrit précédemment, un circuit 16a, une résistance 22a et une diode 62a. Le circuit 16a est relié, de préférence connecté, entre la borne 52 et le nœud 18. Le circuit 16a comprend le transistor 24a et la résistance 26a. Le transistor 24a est de préférence un transistor bipolaire, par exemple un transistor de type NPN. Le transistor 24a est relié, de préférence connecté, entre la borne 52 et le nœud 18. De préférence, une borne de conduction du transistor 24a, de préférence le collecteur du transistor 24a, est reliée, de préférence connectée, à la borne 52 et une autre borne de conduction du transistor 24a, de préférence l'émetteur du transistor 24a, est reliée, de préférence connectée, au nœud 18. La résistance 26a est de préférence reliée entre la borne de commande du transistor 24a, par exemple la base, et le nœud 18. Autrement dit, une borne de la résistance 26a est reliée, de préférence connectée, à la base du transistor 24a et une autre borne de la résistance 26a est reliée, de préférence connectée, au nœud 18.

La résistance 22a du circuit 10a est reliée, de préférence connectée, entre la borne 52 et le nœud de sortie 14a du dispositif 10a. Autrement dit, une borne de la résistance 22a est reliée, de préférence connectée, à la borne 52 et une autre borne de la résistance 22a est reliée, de préférence connectée, au nœud 14a.

Le nœud 14a est par exemple relié à d'autres éléments du circuit 70, étant protégés par les circuits 10. Le nœud 14a est, en outre, relié à une borne d'un circuit 20-1 commun aux dispositifs 10a et 10b. Le nœud 14a est de préférence relié à une borne du circuit 20-1 par la diode 62a. La cathode de la diode 62a est reliée, de préférence connectée, à un nœud 76. L'anode de la diode 62a est reliée, de préférence connectée, au nœud 14a. L'autre borne du circuit 20-1 est reliée, de préférence connectée, au nœud 18.

Le dispositif 10b comprend le transistor 24b, les résistances 26b, 22b et la diode 62b reliés similairement aux éléments du dispositif 10a. La cathode de la diode 62b est ainsi reliée, de préférence connectée, au nœud 76.

La borne 54 est reliée à l'ensemble résistif 66 décrit précédemment, par exemple par une résistance 80. Plus précisément, une borne de la résistance 80 est reliée, de préférence connectée, à la borne 54 et une autre borne de la résistance 80 est reliée, de préférence connectée, à un nœud 74. Le nœud 74 est de préférence relié au nœud 76, correspondant à une borne du circuit 20-1, par une diode 78. La cathode de la diode 78 est reliée, de préférence connectée, au nœud 76 et l'anode de la diode 78 est reliée, de préférence connectée, au nœud 74.

La borne 56 est reliée au dispositif 10c. Le dispositif 10c comprend le transistor 24c et les résistances 22c et 26c reliées entre eux respectivement comme le transistor 24a et les résistances 22a et 26a. Le nœud 14c de sortie du dispositif 10c est relié au nœud 76 par une diode 82. Plus précisément, la cathode de la diode 82 est reliée, de préférence connectée, au nœud 76 et l'anode de la diode 82 est reliée, de préférence connectée, au nœud 14c. En outre, le nœud 14c est relié, de préférence connecté, à une borne d'un circuit 20-2, l'autre borne du circuit 20-2 étant reliée, de préférence connectée, au nœud 18.

Le dispositif 10c, c'est-à-dire le dispositif de protection ESD relié à une des bornes, de préférence la borne d'alimentation, comprend deux circuits tels que le circuit 20 de la figure 1. De préférence, le seuil d'écrêtage du circuit 20-2 est inférieur au seuil du circuit 20-1.

Le mode de réalisation de la figure 4 permet au dispositif 70 de supporter des tensions au niveau des bornes 52, 54 des dispositifs 10a et 10b plus élevées que la tension d'alimentation. La diode 82 permet d'éviter un retour de courant du nœud 76 vers la tension d'alimentation, c'est à dire vers le nœud 14c. Cela est avantageux dans le cas de circuits fonctionnant sur un bus série 12C, où il est possible que les tensions au niveau des lignes SDA, par exemple la borne 54, et/ou SCL, par exemple la borne 52, soient supérieures à la tension d'alimentation du circuit. La diode 82 charge la tension du nœud 76 à la valeur du potentiel de la borne 56, c'est-à-dire la borne sur laquelle est fournie la tension d'alimentation, moins le seuil de la diode 82 (typiquement 600 mV), tout en évitant un retour de courant du nœud 76 vers la tension d'alimentation. La charge du nœud 76 accroît l'impédance d'entrée des bornes 52 et 54, en masquant les courants de fuite, et la capacité parasite du circuit 20-1.

Un avantage des modes de réalisation des figures 3 et 4 est qu'ils permettent de diminuer le nombre de circuits 20, qui sont coûteux en surface.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif (10) de protection contre les décharges électrostatiques comprenant un premier circuit écrêteur (16 ; 16a, 16b, 16c) relié entre un premier nœud (12) et un deuxième nœud (18) et un deuxième circuit écrêteur (20 ; 20-1, 20-2) actif, relié en série avec une première résistance (22 ; 22a, 22b, 22c), le deuxième circuit écrêteur et la première résistance étant reliés entre les premier et deuxième nœuds, le deuxième circuit écrêteur comprenant un transistor (28) à effet de champ à structure métal-oxyde-semiconducteur.

2. Dispositif selon la revendication 1, dans lequel le deuxième circuit et la première résistance sont reliés l'un à l'autre par un troisième nœud (14 ; 14a, 14b, 14c), le troisième nœud étant le nœud de sortie du dispositif.

3. Dispositif selon la revendication 1 ou 2, dans lequel le transistor à effet de champ à structure métal-oxyde-semiconducteur est un transistor à canal N.

4. Dispositif selon l'une quelconque des revendications 1 à 3, dans lequel le deuxième circuit écrêteur a une résistance à l'état passant inférieure à 1 ohm.

5. Dispositif selon l'une quelconque des revendications 1 à 4, dans lequel la première résistance a une valeur inférieure à 100 ohms.

6. Dispositif selon l'une quelconque des revendications 1 à 5, dans lequel le premier circuit écrêteur (16 ; 16a, 16b, 16c) comprend un transistor bipolaire (24 ; 24a, 24b, 24c).

7. Dispositif selon la revendication 6, dans lequel le transistor bipolaire est un transistor de type NPN.

**8.** Dispositif selon la revendication 6 ou 7, dans lequel le premier circuit écrêteur comprend une deuxième résistance (26 ; 26a, 26b, 26c) reliée entre la borne de commande du transistor bipolaire et le deuxième nœud.

**9.** Dispositif selon la revendication 8, dans lequel la deuxième résistance a une valeur inférieure à 1 ohm.

**10.** Dispositif selon l'une quelconque des revendications 1 à 9, dans lequel le seuil d'écrêtage du premier circuit écrêteur est supérieur au seuil d'écrêtage du deuxième circuit écrêteur.

**11.** Circuit électronique comprenant au moins un dispositif selon l'une quelconque des revendications 1 à 10.

**12.** Circuit selon la revendication 11, dans lequel au moins deux dispositifs de protection partagent un même deuxième circuit (20 ; 20-1).

**13.** Circuit selon la revendication 11 ou 12 dans son rattachement à la revendication 2, dans lequel le troisième nœud est relié à une borne du deuxième circuit écrêteur par une diode (62a, 62b, 62c).

**14.** Circuit (70) selon la revendication 11 ou 12 dans son rattachement à la revendication 2 ou selon la revendication 13, dans lequel le troisième nœud de sortie (14c) d'un des dispositifs (10c) est relié à deux deuxièmes circuits (20-1, 20-2), l'un étant partagé avec au moins un autre dispositif.

Fig 1

Fig 2

Fig 3

EP 4 037 125 A1

Fig 4

Europäisches
Patentamt

European
Patent Office

Office européen
des brevets

**RAPPORT DE RECHERCHE EUROPEENNE**

Numéro de la demande

**EP 22 15 3326**

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (IPC) |
|---|---|---|---|
| X | US 2020/014200 A1 (PENG JAMES JENG-JIE<br>[TW] ET AL) 9 janvier 2020 (2020-01-09)<br>* abrégé *<br>* figure 4 *<br>* alinéa [0041] - alinéa [0043] *<br>* alinéa [0048] *<br>----- | 1-14 | INV.<br>H02H9/04<br>H01L27/02 |
| X | US 2019/296545 A1 (ROUVIERE MATHIEU [FR])<br>26 septembre 2019 (2019-09-26)<br>* abrégé *<br>* alinéa [0031] - alinéa [0036] *<br>----- | 1-14 | |
| X<br>A | US 5 500 546 A (MARUM STEVEN E [US] ET AL)<br>19 mars 1996 (1996-03-19)<br>* abrégé; figure 1 *<br>* colonne 1, ligne 18 - ligne 45 *<br>----- | 1,2<br><br>3-14 | |
| X<br>A | US 4 987 465 A (LONGCOR STEVEN W [US] ET<br>AL) 22 janvier 1991 (1991-01-22)<br>* abrégé *<br>* figure 1 *<br>* colonne 3, ligne 43 - colonne 4, ligne<br>10 *<br>----- | 1,2<br><br>3-14 | **DOMAINES TECHNIQUES<br>RECHERCHES (IPC)**<br><br>H02H<br>H01L |
| X<br>A | US 6 304 126 B1 (BERTHIOT DENIS [FR])<br>16 octobre 2001 (2001-10-16)<br>* figure 2 *<br>* colonne 3, ligne 23 - colonne 4, ligne<br>25 *<br>----- | 1,2<br><br>3-14 | |

Le présent rapport a été établi pour toutes les revendications

| Lieu de la recherche | Date d'achèvement de la recherche | Examinateur |
|---|---|---|
| Munich | 1 juin 2022 | Operti, Antonio |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
......................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 22 15 3326

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-06-2022

| Document brevet cité au rapport de recherche | | Date de publication | Membre(s) de la famille de brevet(s) | | | Date de publication |
|---|---|---|---|---|---|---|
| US 2020014200 | A1 | 09-01-2020 | CN | 109274081 | A | 25-01-2019 |
| | | | TW | 202006922 | A | 01-02-2020 |
| | | | US | 2020014200 | A1 | 09-01-2020 |
| US 2019296545 | A1 | 26-09-2019 | FR | 3079348 | A1 | 27-09-2019 |
| | | | US | 2019296545 | A1 | 26-09-2019 |
| US 5500546 | A | 19-03-1996 | AUCUN | | | |
| US 4987465 | A | 22-01-1991 | AUCUN | | | |
| US 6304126 | B1 | 16-10-2001 | AUCUN | | | |

EPO FORM P0460

Pour tout renseignement concernant cette annexe : voir Journal Officiel de l'Office européen des brevets, No.12/82